# EUROPÄISCHE PATENTSCHRIFT

(11) **EP 2 913 882 B1**
(45) Veröffentlichungstag und Bekanntmachung des Hinweises auf die Patenterteilung: **03.05.2017**
(21) Anmeldenummer: 14157257.8
(22) Anmeldetag: 28.02.2014
(51) Int. Cl.: H01M 10/42, H01M 10/48, G01R 31/36

(54) **Batterieüberwachungssystem, Batterieanordnung mit dem Batterieüberwachungssystem und Verfahren zum Betreiben der Batterieanordnung**
Battery monitoring system, battery assembly with the battery monitoring system and method for operating the battery assembly
Système de surveillance de batterie, système de batterie avec système de surveillance de batterie et procédé de fonctionnement du système de batterie

(43) Veröffentlichungstag der Anmeldung: 02.09.2015
(73) Patentinhaber: AEG Power Solutions GmbH, 59581 Warstein-Belecke (DE)
(72) Erfinder: Kempen, Stefan, 59821 Arnsberg (DE); Weissgerber, Tycho, 44357 Dortmund (DE); Barnhusen, Hartmut, 59494 Soest - Müllingsen (DE); Niehaus, Bernd, 59556 Lippstadt (DE)
(74) Vertreter: Graefe, Jörg

(56) Entgegenhaltungen:
- WO-A1-2011/117089
- DE-A1-102012 210 253
- DE-U1-202007 011 399
- US-A1- 2007 190 403

## Beschreibung

Die vorliegende Erfindung betrifft ein Batterieüberwachungssystem nach dem Oberbegriff des Anspruchs 1, eine Batterieanordnung mit einer Vielzahl von Batterien mit einer oder mehreren in einem Gehäuse untergebrachten Sekundärzellen und mit diesem Batterieüberwachungssystem und ein Verfahren zum Betreiben dieser Batterieanordnung.

Batterieanordnungen mit einer Vielzahl von Batterien, die wiederum eine oder mehrere in einem Gehäuse untergebrachte Sekundärzellen aufweisen, werden für verschiedene Zwecke verwendet. Häufig werden Batterieanordnungen an einem Standort verwendet. Bekannt sind aber auch Batterieanordnungen, die in Fahrzeugen eingesetzt werden, um die Stromversorgung in den Fahrzeugen zu ermöglichen.

Batterieanordnungen, die an einem festen Standort verwendet werden, finden sich häufig in Anlagen zur unterbrechungsfreien Stromversorgung (USV). Batterieanordnungen in Anlagen zur unterbrechungsfreien Stromversorgung dienen der Sicherung der Stromversorgung eines einzelnen Verbrauchers oder eines Teilnetzes für den Fall, dass ein Versorgungsnetz ausfällt, an welches der einzelne Verbraucher oder das Teilnetz angeschlossen ist.
Solange das Versorgungsnetz nicht ausfällt, werden die Batterien der Batterieanordnungen von USV-Anlagen aufgeladen oder in einem aufgeladenen Zustand gehalten (Erhaltungsladung).

Bestandteil jeder Sekundärzelle einer Batterie ist ein Elektrolyt. Ohne Elektrolyt funktioniert eine galvanische Zelle nicht. Das Elektrolyt kann in verschiedenen Formen in einer Sekundärzelle vorhanden sein. So gibt es Batterien mit einer flüssigen Elektrolytlösung, Gelbatterien (auch VRLA-Akkumulator genannt) und Vliesbatterien. Für das Funktionieren der Batterie mit flüssiger Elektrolytlösung ist das Vorhandensein einer ausreichenden Menge der Elektrolytlösung von besonderer Bedeutung. Fehlt eine ausreichende Menge der Elektrolytlösung, muss Elektrolytlösung in die Zelle nachgefüllt werden. Eine Überwachung des Füllstands ist ein Anliegen der vorliegenden Erfindung.

Jede Sekundärzelle einer Batterieanordnung hat auch bei gleicher Bauweise und Herstellung aller Sekundärzellen einer Batterieanordnung individuelle Eigenschaften. Diese individuellen Eigenschaften führen zu einem unterschiedlichen Verhalten beim Laden und Entladen einschließlich der Erhaltungsladung und der Selbstentladung. Dieses unterschiedliche Verhalten der Sekundärzellen führt dazu, dass spätestens nach mehreren Landungszyklen die Sekundärzellen unterschiedliche Ladungszustände haben. Das ist aber von Nachteil, da dann die nutzbare Kapazität der Batterieanordnung eingeschränkt ist. Eine Entladung der Batterieanordnung muss dann gestoppt werden, wenn der Ladezustand der schwächsten Sekundärzelle eine untere Schwelle erreicht hat, während die Aufladung der Batterieanordnung dann gestoppt werden muss, wenn die stärkste Sekundärzelle aufgeladen ist.

Ebenso ist wichtig den Totalausfall einer Sekundärzelle in der Batterieanordnung zu erkennen, wenn zum Beispiel eine USV die Batterie im Ladeerhaltungsmodus betreibt damit im Bedarfsfall (Netzausfall) die Batterie auch zur Energielieferung genutzt werden kann. Der Ausfall einer einzigen Sekundärzelle führt nämlich zu einem vollständigen Ausfall der Batterieanordnung.

Die Erfindung widmet sich dem Problem, die Sekundärzellen einer Batterieanordnung in einem gleichen Ladezustand zu halten, insbesondere wenn mehrere Batterien in Reihe (Serie) geschaltet sind und nur von einem Stromrichtergerät geladen bzw. entladen werden.

Übergeordnet ist jedoch das Problem ein Batterieüberwachungssystem vorzuschlagen, welches in einer Batterieanordnung einfach montierbar ist, eine galvanische Trennung einer Zentraleinheit von an den Batterien oder Sekundärzellen angebrachten Batterie- oder Zelleneinheiten aufweist und eine einfache Kommunikation zwischen der Zentraleinheit und den Batterie- oder Zelleneinheiten ermöglicht.

Aus dem Dokument DE 20 2007 011 399 U1 ist eine Anordnung bekannt, bei der eine Zentraleinheit und die Batterie- oder Zelleneinheiten Kommunikationsschnittstellen aufweisen, über welche zumindest die Zentraleinheit mit den Batterie- oder Zelleneinheiten oder umgekehrt drahtlos kommunizieren können.

Die in dem Dokument DE 20 2007 011 399 U1 beschriebene Batterieeinheit weist ein Gewinde zum Einschrauben in einen Schwimmeranschluss einer Batterie.

Das Dokument WO 2001/117089 A1 offenbart eine integrierte Elektronik, die in einer Energiespeicherzelle angeordnet ist. Eine Sende-/Empfangseinheit ist außerhalb der Energiespeicherzelle angeordnet. Die Elektronik ist integraler Bestandteil der Zelle. Die vorliegende Erfindung bezieht sich auf ein Batterieüberwachungssystem nach Anspruch 1, eine Batterieanordnung nach Anspruch 12 sowie ein Verfahren nach Anspruch 13. Bevorzugte Ausführungen sind in den Unteransprüchen enthalten. Bei den Kommunikationsschnittstellen eines erfindungsgemäßen Batterieüberwachungssystems kann es sich um Zigbee, WLAN, Bluetooth, IrDa oder andere Kommunikationsschnittstellen zur drahtlosen Kommunikation handeln.

Eine drahtlose Kommunikation zwischen der Zentraleinheit einerseits und den Batterie- und oder Zelleneinheiten andererseits vereinfacht die Installation eines Batterieüberwachungssystems deutlich, da auf das Verlegen von Kabeln verzichtet werden kann. Dadurch benötigen die Zelleneinheiten nur die Isolationsspannung, die der einer Batteriezelle (z.B. 2,4 V) entspricht und nicht die der gesamten Batterie (z.B. 800 V).

Insbesondere bei Batterieanordnungen mit einer großen Anzahl von Sekundärzellen, zum Beispiel 300 Sekundärzellen, ist das Verkabeln der Einheiten sehr aufwändig und materialintensiv. Dem kann durch die drahtlose Kommunikation abgeholfen werden.

Zudem wird durch die Schnittstelle zur drahtlosen Kommunikation eine galvanische Trennung von Komponenten des Batterieüberwachungssystems erreicht. Die Batterie- oder Zelleinheiten können in bevorzugter Weise auf einem Batteriepol formschlüssig befestigt oder aufgesteckt werden. Dazu können die Batterie- oder Zelleneinheiten Ausnehmungen aufweisen, in welche die Batteriepole eingeführt werden können. als Batteriepol in diesem Sinne ist nicht nur der Anschlusspol einer Batterie anzusehen, sondern auch der aus einem Gehäuse nach aussen geführte Anschlusspol einer Sekundärzelle. Gemäß der Erfindung kann das Batterieüberwachungssystem Sensoren zur Messung aufweisen. Darunter kann ein Sensor zur Messung eines Füllstands einer Elektrolytlösung in den Batterien oder den Sekundärzellen sein. Andere Sensoren können Spannungssensoren und Temperatursensoren sein. Die Sensoren können ganz oder teilweise Teil der Batterie- oder Zelleneinheiten sein oder mit den Batterie- oder Zelleneinheiten verbindbar sein.

Die Sensoren zur Messung des Füllstands können kapazitive Sensoren sein. Die kapazitiven Sensoren können ein Paar Elektroden aufweisen, die mit Abstand zueinander auf Gehäusen der Batterien bzw. der Sekundärzellen anbringbar sind. Die Elektroden können gabelähnlich, rechenähnlich oder kammähnlich gestaltet sein. Die Elektroden können Kammelektroden sein. Die Elektroden sind so zu einander angeordnet, dass Zinken einer Elektrode eines Elektrodenpaars in Zwischenräume zwischen Zinken einer anderen Elektrode des Elektrodenpaars eingreifen.

Die Batterie- oder Zelleneinheiten können geeignet und eingerichtet sein, eine zur Funktion notwendige elektrische Energie aus der zu überwachenden Batterie oder Sekundärzelle zu beziehen. Die Batterie- oder Zelleneinheiten können dazu über ein Kabel oder eine Brücke mit einem Batteriepol verbunden sein, während die Batterie- oder Zelleneinheiten an dem anderen Batteriepol angebracht sind. Ebenso ist es möglich, dass die Batterie- oder Zelleneinheiten mit beiden Batteriepolen der Batterien oder Sekundärzellen über Kabel oder Brücken verbunden sind.

Die in dem Dokument WO 2001/117089 A1 offenbarte, in die Batterie integrierte Elektronik weist zum passiven Balancing einen zuschaltbaren Entladewiderstand auf. Über einen Transistor kann der Widerstand parallel zu den Elektroden der Zellen geschaltet werden, um ein kontrolliertes entladen zu ermöglichen.

Der Erfindung liegt die Aufgabe zu Grunde, den Ladungszustand einer Zelle- oder einer Batterie zu steuern.

Diese Aufgabe wird erfindungsgemäß Durch ein Batterieüberwachungssystem nach Anspruch 1, eine Batterieanordnung nach Anspruch 12 sowie nach dem Verfahren des Anspruchs 13 gelöst. Dabei wird die Leistung einzelner Komponenten der Batterie- oder Zelleneinheiten von der Zentraleinheit gesteuert. Das ermöglicht es, das Entladen oder Laden der Batterien oder Sekundärzellen zu beeinflussen und den Ladezustand der Batterien und Zellen einer Batterieanordnung durch die Zentraleinheit zu koordinieren. Die Batterien oder Sekundärzellen, denen die Batterie- oder Zelleneinheiten zugeordnet sind, deren Komponenten mehr verbrauchen als die Komponenten anderer Batterie- oder Zelleneinheiten, werden langsamer aufgeladen oder schneller entladen, als wenn eine Einflussnahme auf die Leistung der Komponenten unterbliebe. Dadurch lässt sich der Landungszustand der Sekundärzellen oder Batterien einer Batterieanordnung angleichen oder ausgleichen.Von der Zentraleinheit wird die Sendeleistung von Sendern der Batterie- oder Zelleneinheiten zu gesteuert. Dieses ist eine besonders einfache Möglichkeit, den Ladezustand der Batterien oder Sekundärzellen zu beeinflussen, da dazu keine besonderen energieverbrauchenden Komponenten in den Batterie- oder Zelleneinheiten vorgesehen sein müssen, Ebenso ist es möglich, dass von der Zentraleinheit die Leistung von LEDs der Batterie- oder Zelleneinheiten gesteuert werden. Bei diesen LEDs kann es sich um Status-LEDs handeln, die einen Zustand der Batterie- oder Zelleneinheiten oder den Zustand von Komponenten der Batterie- oder Zelleneinheiten anzeigen. Auch diese können in den Batterie- oder Zelleneinheiten vorhanden sein, so dass nur für das Entladen oder verzögerte Aufladen der Batterien oder Sekundärzellen keine besonderen Komponenten vorgesehen sein müssen.

Gemäß der Erfindung ist es möglich, dass in den Batterie- oder Zelleneinheiten Widerstände vorgesehen sind, über welche die Batterien oder Sekundärzellen durch die Zentraleinheit gesteuert entlanden werden können, um den Ladezustand der Batterie oder Sekundärzelle, an welcher die Batterie- oder Zelleneinheiten mit den Widerständen vorgesehen sind, gezielt zu beeinflussen.

Ein erfindungsgemäßes Batterieüberwachungssystem kann ein Teil einer erfindungsgemäßen Batterieanordnung umfassend eine Vielzahl von Batterien mit einer oder mehreren Sekundärzellen sein. Bei einer solchen Batterieanordnung sind die Batterie- oder Zelleneinheiten an den Batterien oder Sekundärzellen angebracht.

Eine erfindungsgemäße Batterieanordnung kann so betrieben werden, dass Werte physikalischer Größen der Batterien oder Sekundärzellen, die mittels der Sensoren der Batterie- oder Zelleneinheiten gemessen werden, an die Zentraleinheit übermittelt werden und mittels der Zentraleinheit die Leistung von Komponenten der Batterie- oder Zelleneinheiten gesteuert wird, um einen gleichen Ladungszustand der Batterien oder Sekundärzellen zu erreichen.

Weitere Merkmale und Vorteile der vorliegenden Erfindung werden deutlich anhand der nachfolgenden Beschreibung eines Ausführungsbeispiels unter Bezugnahme auf die beiliegenden Abbildungen. Darin zeigen in schematischer Darstellung:
- Fig. 1: ein Batterieanordnung,

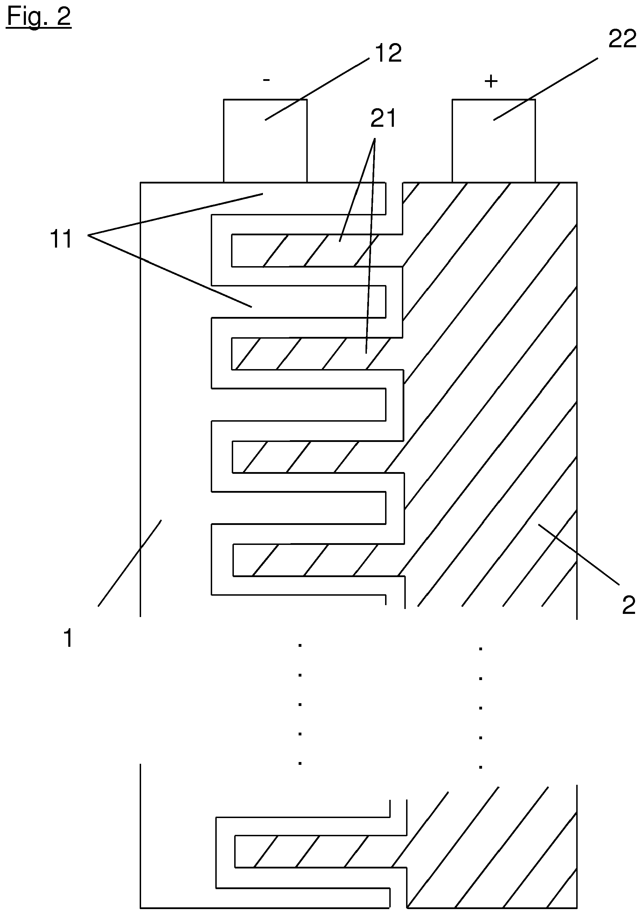

- Fig. 2: Elektroden eines kapazitiven Füllstandssensors und

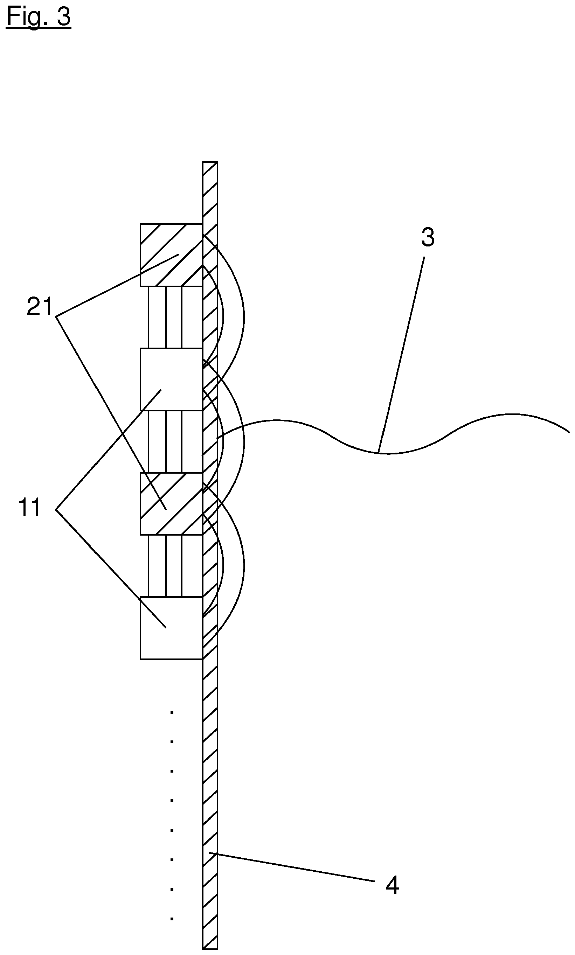

- Fig. 3: einen Teil einer Batterie mit den Elektroden des kapazitiven Füllstandssensors im Schnitt.

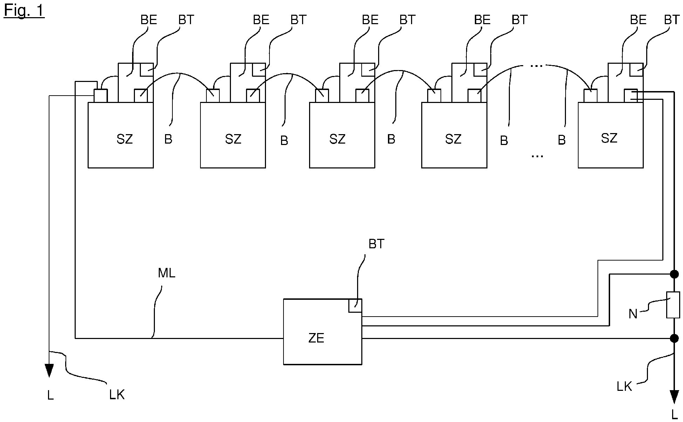

Die in der Figur 1 schematisch dargestellte Batterieanordnung weist eine Anzahl von Sekundärzellen SZ auf, die durch Brücken B elektrisch in Reihe geschaltet sind. Ein Ende und ein Anfang der Reihenschaltung ist mit Lastkabeln LK verbunden, über die die Batterieanordnung mit einer Last L verbunden ist. Die Last ist ebenso wenig dargestellt wie ein Ladegerät oder ein Umrichter mittels dessen die Sekundärzellen der Batterieanordnung aufgeladen werden.

An je einem Batteriepol jeder Sekundärzelle SK ist eine Batterie- oder Zelleneinheit BE angebracht, vorzugsweise aufgesteckt. Die Batterie- oder Zelleneinheit BE ist über ein Kabel mit dem jeweils anderen Batteriepol der Sekundärzelle verbunden.

In den Batterie- oder Zelleneinheiten BE sind verschiedene Sensoren zur Überwachung des Zustands der Sekundärzellen SZ vorgesehen, insbesondere Spannungssensoren zur Überwachung der Spannung an den Batteriepolen der Sekundärzellen SZ, Temperatursensoren zum Überwachen der Temperaturen der Sekundärzellen SZ, Füllstandssensoren zur Überwachung des Elektrolytlösungsfüllstands in den Sekundärzellen SZ.

Der zur Temperaturmessung vorgesehene Sensor kann einen Temperatur-Spannungswandler oder einen Temperatur-Stromwandler aufweisen, der unmittelbaren Kontakt mit einem Batteriepol hat. Da Batteriepole in der Regel in das Innere der Batterie oder Sekundärzelle hineinreichen, und die Batteriepole gut Wärmeleiter sind, kann durch eine solche Anordnung der Wandler unmittelbar am Batteriepol die Temperatur in der Batterie oder der Sekundärzelle mit guter Genauigkeit erfasst werden.

Die Batterie- oder Zelleneinheiten BE weisen Kommunikationsschnittstelle zur drahtlosen Kommunikation mit einer Zentraleinheit ZE auf, die dazu ebenfalls eine Kommunikationsschnittstelle zur drahtlosen Kommunikation aufweist. Bei den Kommunikationsschnittstellen kann es sich um _{[KS1]}Zigbee-Schnittstelle handeln.

Die Batterie- oder Zelleneinheiten BE und die Zentraleinheit ZE zusammen bilden ein erfindungsgemäßes Batteriemesssystem.

Die erste und die letzte Sekundärzelle SZ der Reihenschaltung der Sekundärzellen SZ ist über Leitungen ML mit der Zentraleinheit ZE verbunden. Damit ist es möglich, die Spannung über der Reihenschaltung durch die Zentraleinheit ZE zu erfassen.

Ebenso ist es möglich, dass in einem der Lastkabel LK ein Nebenwiderstand N angeordnet ist, um den Strom, der von der Reihenschaltung abgegeben wird, zu erfassen. Die Spannung über dem Nebenwiderstand N wird von der Zentraleinheit ZE erfasst und daraus der Strom berechnet. Selbstverständlich kann auch jede andere Art der Strommessung genutzt werden.

Bei den Elektroden eines kapazitiven Füllstandssensors des erfindungsgemäßen Batterieüberwachungssystems kann es sich um sogenannte Kammelektroden 1, 2 handeln. Diese weisen Zinken 11, 21 auf, wobei die Zinken 11 einer ersten der beiden Elektroden eines Elektrodenpaares 1, 2 zwischen zwei Zinken 21 der zweiten der beiden Elektroden liegen. Die Elektroden 1, 2 sind auf der Außenseite eines Gehäuses 4 der Sekundärzelle befestigt, vorzugsweise aufgeklebt. Die Elektroden überdecken dabei vorzugsweise den gesamten Bereich, in dem sich der Flüssigkeitsspiegel der in die Sekundärzelle eingefüllten Elektrolytlösung bewegen kann. Anschlüsse 12, 22 der Elektroden sind über nicht dargestellte Leitungen mit je einer Batterie- oder Zelleneinheit BE verbunden.

Durch das Anlegen einer Spannung zwischen den Zinken der beiden Elektroden eines der Elektrodenpaare 1, 2 wird ein elektrisches Feld aufgebaut. Das von dem Kammelektrodenpaar 1, 2 aufgebaute elektrische Feld besteht natürlich hauptsächlich zwischen den Zinken 11, 21 (Hauptfeld) und wird nicht durch den Flüssigkeitsspiegel 3 in der Sekundärzelle SZ beeinflusst. Neben dem Hauptfeld wird aber auch ein sogenanntes Streufeld aufgebaut, das auch einen Bereich innerhalb der Sekundärzelle SZ durchdringt, in dem sich die Elektrolytlösung befindet. Die Materialeigenschaften in einem Bereich der Elektrolytlösung weichen stark von den Eigenschaften des nicht mit der Elektrolytlösung gefüllten Bereiches der Sekundärzelle SZ ab. Charakteristische Parameter dieser Materialeigenschaften sind die Permittivität (dielektrische Leitfähigkeit), d.h. die Durchlässigkeit eines Materials für elektrische Felder und die elektrische Leitfähigkeit. Beide Eigenschaften, vor allem aber die Permittivität , bestimmen die im Streufeld wirksame elektrische Kapazität, die an der Elektrodenanordnung messbar ist.

## Patentansprüche

1. Batterieüberwachungssystem mit wenigstens einer Zentraleinheit (ZE) und an Batterien oder Sekundärzellen (SK) anbringbaren Batterie- oder Zelleneinheiten (BE), wobei jede Batterie- oder Zelleneinheit Sensoren zum Erfassen physikalischer Größen in oder an der Batterie oder Sekundärzelle (SK) aufweist, und wobei die Zentraleinheit (ZE) und die Batterie- oder Zelleneinheiten (BE) Kommunikationsschnittstellen (BT) aufweisen, über welche zumindest die Zentraleinheit (ZE) mit den Batterie- oder Zelleneinheiten (BE) oder umgekehrt kommunizieren können, wobei die Batterie- oder Zelleneinheiten (BE) geeignet und eingerichtet sind, eine zur Funktion notwendige elektrische Energie aus der zu überwachenden Batterie oder Sekundärzelle (SK) zu beziehen,
wobei von der Zentraleinheit (ZE) die Sendeleistung von Sendern der Batterie- oder Zelleneinheiten (BE) steuerbar ist,
**dadurch gekennzeichnet,**
**dass** von der Zentraleinheit (ZE) die Sendeleistung der Sender der Batterie- oder Zelleneinheiten (BE) zum Zweck eines Angleichens oder Ausgleichens des Ladungszustandes der Sekundärzellen oder Batterien einer Batterieanordnung steuerbar ist, wodurch das Laden und Entladen der Batterien oder Sekundärzellen (SK) beeinflussbar ist, um Batterien oder Sekundärzellen (SK), denen die Batterie- oder Zelleneinheiten zugeordnet sind, deren Sender mehr Energie verbrauchen als die Sender anderer Batterie- oder Zelleneinheiten (BE), langsamer aufzuladen oder schneller zu entladen, als wenn eine Einflussnahme auf die Sendeleistung der Sender unterbliebe.

2. Batterieüberwachungssystem nach Anspruch 1, **dadurch gekennzeichnet, dass** die Kommunikationsschnittstellen (BT) Schnittstellen für eine drahtlose Kommunikation sind.

3. Batterieüberwachungssystem nach Anspruch 1 oder 2, **dadurch gekennzeichnet, dass** die Batterie- oder Zelleneinheiten (BE) Ausnehmungen aufweisen, in welche die Batteriepole einführbar sind.

4. Batterieüberwachungssystem nach einem der Ansprüche 1 bis 3, **dadurch gekennzeichnet, dass** das Batterieüberwachungssystem Sensoren zur Messung eines Füllstands einer Elektrolytlösung in den Batterien oder den Sekundärzellen (SK) aufweist.

5. Batterieüberwachungssystem nach Anspruch 4, **dadurch gekennzeichnet, dass** die Sensoren zur Messung des Füllstands Teil der Batterie- oder Zelleneinheiten (BE) sind oder mit den Batterie- oder Zelleneinheiten (BE) verbindbar sind.

6. Batterieüberwachungssystem nach Anspruch 5, **dadurch gekennzeichnet, dass** die Sensoren zur Messung des Füllstands kapazitive Sensoren sind.

7. Batterieüberwachungssystem nach Anspruch 6, **dadurch gekennzeichnet, dass** die Sensoren ein Paar Elektroden (1, 2) aufweisen, die mit Abstand zueinander auf Gehäusen der Batterien bzw. der Sekundärzellen (SK) angebracht sind.

8. Batterieüberwachungssystem nach Anspruch 7, **dadurch gekennzeichnet, dass** die Elektroden (1, 2) gabelähnlich, rechenähnlich oder kammähnlich gestaltet sind

9. Batterieüberwachungssystem nach Anspruch 8, **dadurch gekennzeichnet, dass** die Elektroden (1, 2) so zu einander angeordnet sind, das Zinken (11) einer Elektrode (1) eines Elektrodenpaars (1, 2) in Zwischenräume zwischen Zinken (21) einer anderen Elektrode (2) des Elektrodepaars (1, 2) eingreifen.

10. Batterieüberwachungssystem nach einem der Ansprüche 1 bis 9, **dadurch gekennzeichnet, dass** von der Zentraleinheit (ZE) LEDs der Batterie- oder Zelleneinheiten (BE) steuerbar sind.

11. Batterieüberwachungssystem nach Anspruch 10, **dadurch gekennzeichnet, dass** die LEDs Status-LEDs sind, die einen Zustand der Batterie- oder Zelleneinheiten (BE) oder den Zustand von Komponenten der Batterie- oder Zelleneinheiten (BE) anzeigen.

12. Batterieanordnung aufweisend eine Vielzahl von Batterien mit einer oder mehreren Sekundärzellen (SK) und einem Batterieüberwachungssystem nach einem der Ansprüche 1 bis 11, **dadurch gekennzeichnet, dass** die Batterie- oder Zelleneinheiten (BE) an Batteriepolen der Batterien oder Sekundärzellen (SK) angebracht sind.

13. Verfahren zum Betreiben dieser Batterieanordnung nach Anspruch 12, **dadurch gekennzeichnet, dass** mittels Sensoren der Batterie- oder Zelleneinheiten (BE) gemessene Werte physikalischer Größen der Batterien oder Sekundärzellen (SK) an die Zentraleinheit (ZE) übermittelt werden und mittels der Zentraleinheit die Leistung von Komponenten der Batterie- oder Zelleneinheiten (BE) gesteuert wird, um einen gleichen Ladungszustand der Batterien oder Sekundärzellen (SK) zu erreichen.

## Claims

1. Battery monitoring system having at least one central unit (ZE) and battery or cell units (BE) which can be fitted to batteries or secondary cells (SK), each battery or cell unit having sensors for capturing physical variables in or at the battery or secondary cell (SK), and the central unit (ZE) and the battery or cell units (BE) having communication interfaces (BT) via which at least the central unit (ZE) can communicate with the battery or cell units (BE) or vice versa,
the battery or cell units (BE) being suitable and set up for obtaining electrical energy required for the function from the battery or secondary cell (SK) to be monitored,
the central unit (ZE) being able to control the transmission power of transmitters of the battery or cell units (BE),
**characterized in that**
the central unit (ZE) can control the transmission power of the transmitters of the battery or cell units (BE) for the purpose of adjusting or compensating the state of charge of the secondary cells or batteries of a battery arrangement, as a result of which the charging and discharging of the batteries or secondary cells (SK) can be influenced in order to charge batteries or secondary cells (SK), which are assigned the battery or cell units whose transmitters consume more energy than the transmitters of other battery or cell units (BE), more slowly or to discharge them more quickly than if there were no influence on the transmission power of the transmitters.

2. Battery monitoring system according to Claim 1, **characterized in that** the communication interfaces (BT) are interfaces for wireless communication.

3. Battery monitoring system according to Claim 1 or 2, **characterized in that** the battery or cell units (BE) have recesses into which the battery poles can be inserted.

4. Battery monitoring system according to one of Claims 1 to 3, **characterized in that** the battery monitoring system has sensors for measuring a filling level of an electrolyte solution in the batteries or secondary cells (SK).

5. Battery monitoring system according to Claim 4, **characterized in that** the sensors for measuring the filling level are part of the battery or cell units (BE) or can be connected to the battery or cell units (BE).

6. Battery monitoring system according to Claim 5, **characterized in that** the sensors for measuring the filling level are capacitive sensors.

7. Battery monitoring system according to Claim 6, **characterized in that** the sensors have a pair of electrodes (1, 2) which are fitted at a distance from one another on housings of the batteries or secondary cells (SK).

8. Battery monitoring system according to Claim 7, **characterized in that** the electrodes (1, 2) are fork-like, rake-like or comb-like.

9. Battery monitoring system according to Claim 8, **characterized in that** the electrodes (1, 2) are arranged with respect to one another in such a manner that prongs (11) of one electrode (1) of an electrode pair (1, 2) engage in intermediate spaces between prongs (21) of another electrode (2) of the electrode pair (1, 2).

10. Battery monitoring system according to one of Claims 1 to 9, **characterized in that** the central unit (ZE) can control LEDs of the battery or cell units (BE).

11. Battery monitoring system according to Claim 10, **characterized in that** the LEDs are status LEDs which indicate a state of the battery or cell units (BE) or the state of components of the battery or cell units (BE).

12. Battery arrangement having a multiplicity of batteries having one or more secondary cells (SK) and a battery monitoring system according to one of Claims 1 to 11, **characterized in that** the battery or cell units (BE) are fitted to battery poles of the batteries or secondary cells (SK).

13. Method for operating this battery arrangement according to Claim 12, **characterized in that** values of physical variables of the batteries or secondary cells (SK) which are measured using sensors of the battery or cell units (BE) are transmitted to the central unit (ZE) and the central unit is used to control the power of components of the battery or cell units (BE) in order to achieve an identical state of charge of the batteries or secondary cells (SK).

## Revendications

1. Système de surveillance de batterie, comprenant au moins une unité centrale (ZE) et des unités de batterie ou de cellule (BE) pouvant être montées sur des batteries ou des cellules secondaires (SK), chaque unité de batterie ou de cellule possédant des capteurs destinés à collecter des grandeurs physiques dans ou sur la batterie ou la cellule secondaire (SK), et l'unité centrale (ZE) ainsi que les unités de batterie ou de cellule (BE) possédant des interfaces de communication (BT) par le biais desquelles au moins l'unité centrale (ZE) peut communiquer avec les unités de batterie ou de cellule (BE) ou inversement,
les unités de batterie ou de cellule (BE) étant adaptées et conçues pour percevoir de la batterie ou de la cellule secondaire (SK) à surveiller l'énergie électrique nécessaire au fonctionnement,
la puissance d'émission d'émetteurs des unités de batterie ou de cellule (BE) pouvant être commandée par l'unité centrale (ZE),
**caractérisé en ce**
**que** la puissance d'émission des émetteurs des unités de batterie ou de cellule (BE) peut être commandée par l'unité centrale (ZE) à des fins d'alignement ou d'équilibrage de l'état de charge des cellules secondaires ou des batteries d'un arrangement de batteries, ce par quoi la charge et la décharge des batteries ou des cellules secondaires (SK) peuvent être influencées afin que les batteries ou les cellules secondaires (SK), auxquelles sont associées les unités de batterie ou de cellule dont les émetteurs consomment plus d'énergie que les émetteurs des autres unités de batterie ou de cellule (BE), soient chargées plus lentement ou déchargées plus rapidement que si une influence sur la puissance d'émission des émetteurs ne s'appliquait pas.

2. Système de surveillance de batterie selon la revendication 1, **caractérisé en ce que** les interfaces de communication (BT) sont des interfaces pour une communication sans fil.

3. Système de surveillance de batterie selon la revendication 1 ou 2, **caractérisé en ce que** les unités de batterie ou de cellule (BE) possèdent des cavités dans lesquelles peuvent être introduites les bornes de batterie.

4. Système de surveillance de batterie selon l'une des revendications 1 à 3, **caractérisé en ce que** le système de surveillance de batterie possède des capteurs destinés à mesurer un niveau d'une solution d'électrolyte dans les batteries ou les cellules secondaires (SK).

5. Système de surveillance de batterie selon la revendication 4, **caractérisé en ce que** les capteurs destinés à mesurer le niveau font partie des unités de batterie ou de cellule (BE) ou peuvent être reliés aux unités de batterie ou de cellule (BE).

6. Système de surveillance de batterie selon la revendication 5, **caractérisé en ce que** les capteurs destinés à mesurer le niveau sont des capteurs capacitifs.

7. Système de surveillance de batterie selon la revendication 6, **caractérisé en ce que** les capteurs possèdent une paire d'électrodes (1, 2) qui sont montées avec un espacement entre elles sur des boîtiers des batteries ou des cellules secondaires (SK).

8. Système de surveillance de batterie selon la revendication 7, **caractérisé en ce que** les électrodes (1, 2) sont configurées en forme de fourche, en forme de râteau ou en forme de peigne.

9. Système de surveillance de batterie selon la revendication 8, **caractérisé en ce que** les électrodes (1, 2) sont disposées l'une par rapport à l'autre de telle sorte que les dents (11) d'une électrode (1) d'une paire d'électrodes (1, 2) viennent en prise dans des espaces intermédiaires entre les dents (21) d'une autre électrode (2) de la paire d'électrodes (1, 2).

10. Système de surveillance de batterie selon l'une des revendications 1 à 9, **caractérisé en ce que** des LED des unités de batterie ou de cellule (BE) peuvent être commandées par l'unité centrale (ZE).

11. Système de surveillance de batterie selon la revendication 10, **caractérisé en ce que** les LED sont des LED d'état qui indiquent un état des unités de batterie ou de cellule (BE) ou l'état de composants des unités de batterie ou de cellule (BE).

12. Arrangement de batterie possédant une pluralité de batteries comprenant une ou plusieurs cellules secondaires (SK) et un système de surveillance de batterie selon l'une des revendications 1 à 11, **caractérisé en ce que** les unités de batterie ou de cellule (BE) sont montées sur les bornes de batterie des batteries ou des cellules secondaires (SK).

13. Procédé pour faire fonctionner cet arrangement de batterie selon la revendication 12, **caractérisé en ce que** des valeurs des grandeurs physiques des batteries ou des cellules secondaires (SK) mesurées au moyen de capteurs des unités de batterie ou de cellule (BE) sont communiquées à l'unité centrale (ZE) et la puissance de composants des unités de batterie ou de cellule (BE) est commandée au moyen de l'unité centrale afin de parvenir à un état de charge identique des batteries ou des cellules secondaires (SK).
